# EUROPEAN PATENT SPECIFICATION

(11) **EP 1 807 866 B1**
(45) Date of publication and mention of the grant of the patent: **06.03.2013**
(21) Application number: 05851232.8
(22) Date of filing: 20.10.2005
(51) Int. Cl.: B08B 7/00

(54) **EUV COLLECTOR DEBRIS MANAGEMENT**
HANDHABUNG DER ABLAGERUNGEN EINES EUV-KOLLEKTORS
GESTION DES DEBRIS AU NIVEAU D'UN COLLECTEUR EUV

(30) Priority: 01.11.2004 US 979945
(43) Date of publication of application: 18.07.2007
(73) Proprietor: Cymer, Inc., San Diego, CA 92127-2413 (US)
(72) Inventor: PARTLO, William, N., Poway, CA 92064 (US); FOMENKOV, Igor, V., San Diego, CA 92129 (US); ERSHOV, Alexander, I., San Diego, CA 92127 (US); OLDHAM, William, Orinda, CA 94563 (US); HEMBERG, Oscar, La Jolla, CA 92037 (US); MARX, William, F., Oakland California 94608 (US)
(74) Representative: Grünecker, Kinkeldey, Stockmair & Schwanhäusser
(86) International application number: PCT/US2005/037725
(87) International publication number: WO 2006/049886

(56) References cited:
- EP-A1- 1 643 310
- WO-A2-2006/020080
- US-A1- 2004 007 246
- US-A1- 2004 179 178
- US-B1- 6 589 709

## Description

### FIELD OF THE INVENTION

The present invention relates to plasma produced Extreme Ultraviolet ("EUV") light generation debris management.

### RELATED APPLICATIONS

This application claims priority to United States Patent Application Ser. No. 10/979,945 entitled EUV COLLECTOR DEBRIS MANAGEMENT, filed on November 1, 2004, Attorney Docket No. 2004-0088-01, which is related to United States Patent Applications Ser. Nos. 10/409,254, entitled EXTREME ULTRAVIOLET LIGHT SOURCE, filed on April 8, 2003, Attorney Docket No. 2002-0030-01, and 10/798,740, entitled COLLECTOR FOR EUV LIGHT SOURCE, filed on March 10, 2004, Attorney Docket No. 2003-0083-01, and 10/615,321, entitled A DENSE PLASMA FOCUS RADIATION SOURCE, filed on July 7, 2003, Attorney docket No. 2003-0004-01, and 10/742,233, entitled DISCHARGE PRODUCED PLASMA EUV LIGHT SOURCE, filed on December 18, 2003, Attorney docket No. 2003-0099-01, and 10/803,526, entitled A HIGH REPETITION RATE LASER PRODUCED PLASMA EUV LIGHT SOURCE, filed on March 17, 2004, Attorney docket No. 2003-0125-01, and, entitled A DENSE PLASMA FOCUS RADIATION SOURCE, filed on May 21, 2003, Attorney Docket No. 2003-0132-01, and 10/900,836, entitled EUV LIGHT SOURCE, filed on July 27, 2004, Attorney docket No. 2004-0044-01, all co-pending and assigned to the common assignee of the present application, the disclosures of each of which are hereby incorporated by reference.

### BACKGROUND OF THE INVENTION

EUV light generation utilizing a plasma formed from metals such as tin in the form of a target for plasma initiation by irradiation of the target, e.g., a droplet of liquid tin in a laser produced plasma EUV light generator or in a discharged produced deep plasma focus produced plasma using, e.g., tin, as the plasma source have been proposed in the art. A problem with tin in such applications has been the removal of plasma produced debris from optical surfaces in the EUV light source production chamber. Such optical surfaces may be, e.g., reflective surfaces, e.g., in a collector, e.g., using mutilayer mirrors with many stacked layers forming the reflecting optic or a few layers forming a grazing angle of incidence reflecting surface or may be transmitting surfaces, e.g., lenses and windows used, e.g., to direct and/or focus a laser beam(s) on the plasma production target for LPP or for various metrology uses. Lithium, tin and Xenon, among other elements have been proposed as plasma production source materials for plasma produced EUV light generation, both of the discharged produced plasma ("DPP") variety, otherwise sometimes referred to as Dense Plasma Focus ("DPF"P or Dense Plasma Pinch ("DPP") or the Laser Produced Plasma ("LPP") variety. One of the troubling aspects of tin as a target according to the art is the perceived inability to remove tin from optical elements critical to the operation of the DPP or LPP apparatus for producing EUV light, e.g., the primary collector mirror in either a DPP or LPP system, or from such optics as windows used, e.g., for metrology and/or lenses used for, e.g., metrology and/or focusing or directing of the laser light pulses to the plasma initiation site for LPP. For lithium as discussed, e.g., in the above referenced co-pending applications, several strategies for lithium debris removal exist, e.g., simply heating the reflective surface of the mirror or other optical element to, e.g., about 450-500°C and evaporate the lithium from the mirror surface.

The halides and halides of other possible target materials have been proposed as the source of the target material as discussed in WO03/094581 A1, entitled METHOD OF GENERATION F EXTREME ULTRAVIOLET RADIATION, published on November 13, 2003. Other methods for removing debris from optical surfaces by using a halogen are disclosed in US 2004/0007246, EP1,643,310 and WO 2006/020080.

Applicants propose various solutions to the difficulties in debris mitigation with such targets as tin.

### SUMMARY OF THE INVENTION

A method and apparatus are disclosed that may comprise an EUV light producing mechanism utilizing an EUV plasma source material comprising a material that will form an etching compound, which plasma source material produces EUV light in a band around a selected center wavelength comprising: an EUV plasma generation chamber; an EUV light collector contained within the chamber having a reflective surface containing at least one layer comprising a material that does not form an etching compound and/or forms a compound layer that does not significantly reduce the reflectivity of the reflective surface in the band; an etchant source gas contained within the chamber comprising an etchant source.material with which the plasma source material forms an etching compound, which etching compound has a vapor pressure that will allow etching of the etching compound from the reflective surface. The etchant source material may comprises a halogen or halogen compound. The etchant source material may be selected based upon the etching being stimulated in the presence of photons of EUV light and/or DUV light and/or any excited energetic photons with sufficient energy to stimulate the etching of the plasma source material. The apparatus may further comprise an etching stimulation plasma generator providing an etching stimulation plasma in the working vicinity of the reflective surface; and the etchant source material may be selected based upon the etching being stimulated by an etching stimulation plasma. There may also be an ion accelerator accelerating ions toward the reflective surface. The ions may comprise etchant source material. The apparatus and method may comprise an EUV light producing mechanism utilizing an EUV plasma source material comprising a material that will form an etching compound, which plasma source material produces EUV light in a band around a selected center wavelength which may comprise an EUV plasma generation chamber; a subsystem opening in the chamber comprising an optical element within the subsystem opening exposed to EUV, comprising a material that does not form an etching compound and/or forms a compound layer that does not significantly reduce the optical performance of the material; an etchant source gas contained in operative contact with the optical element comprising an etchant source material with which the plasma source material forms an etching compound, which etching compound has a vapor pressure that will allow etching of the etching compound from the optical element. The etchant source material and related gases may be as described above.

### BRIEF DESCRIPTION OF THE DRAWINGS

FIG.'s 1A-1I show the transmissiveness of various halogen containing gases for light in the EUV range around about 13.5nm, for 1mT, 10mT and 100mT chamber pressure;
FIG. 1J shows a similar plot for Xenon;
FIG. 2 shows the atomic flux of Tin ions onto mirrors of various radius according to aspects of an embodiment of the present invention;
FIG. 3 shows the atomic flux onto a mirror of halogen gases Chlorine and Bromine onto a mirror according to aspects of an embodiment of the present invention;
FIG. 4 illustrates schematically a debris mitigation arrangement for an EUV light source collector according to aspects of an embodiment of the present invention;
FIG. 5 shows schematically an EUV light source optical element debris mitigation arrangement according to aspects of an embodiment of the present invention.

### DETAILED DESCRIPTION OF PREFERRED EMBODIMENTS

At least one tin hydride investigated by applicants, e.g., SnH₄ has a large vapor pressure at temperatures at or below 450-500°C. and an activation energy to form the compound from a tin halogen (hydrogen) reaction is high and thus requires a large amount of power applied to the mirror surface for formation. Applicants have considered other possible halogen forming compounds (halides and hydrides) made from EUV target materials currently under consideration, e.g., tin.

Some relevant values are shown below in Table I.

**TABLE I**

| Compound | Melting Point (°C) | Boiling Point (°C) |
|---|---|---|
| SnH₄ | -146 | -52 |
| SnF₂ | 213 | 850 |
| SnF₄ | --- | 705 |
| SnCl₂ | 247 | 623 |
| SnCL₄ | -33 | 114 |
| SnBr₂ | 216 | 620 |
| SnBr₄ | 31 | 202 |
| SnI₂ | 320 | 714 |
| SnI₄ | 143 | 364 |
| H₂ | -259 | -252 |
| F₂ | -219 | -188 |
| Cl₂ | -101 | -34 |
| Br₂ | -73 | 59 |
| I₂ | 113 | 184 |
| Xe | -111 | -108 |

The above noted Phillips patent application contains plots of pressure vs. temperature for most of these compounds and shows that most have higher vapor pressure at any given temperature than lithium (lithium's boiling point is 1342°C).

Applicants have also considered whether acceptable EUV light within a given band, e.g., centered at around 13.5nm can be obtained with reasonable values of gas pressure. The plots of FIG.'s 1A-1I show transmission vs. wavelength for various tin halides according to with the data taken from the CXRO web site. These plots are for three pressures 1mT, 10mT and 100mT, all at 22°C and through a gas column of one meter. Applicants have also investigated this transmissivity for the same pressures for each compound at 400°C and found only a small improvement in transmission at the higher temperature. These plots are not expected to be perfectly accurate, but instead give a guide as to an approximate acceptable upper limit of gas pressure.

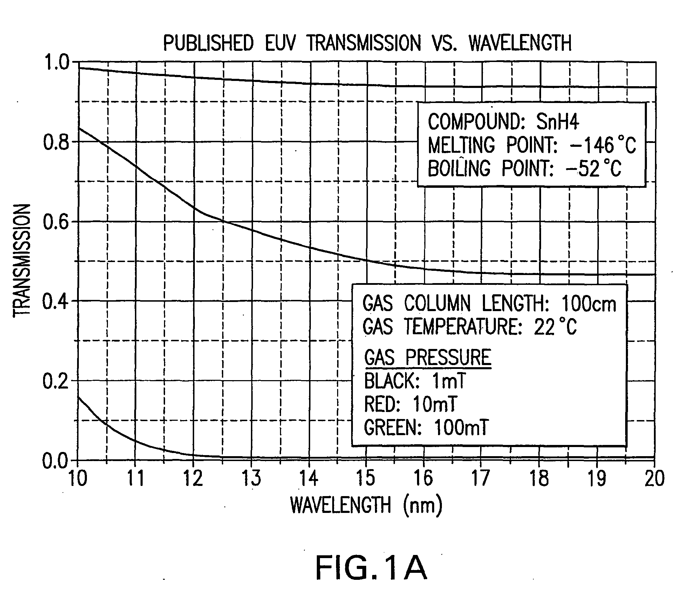

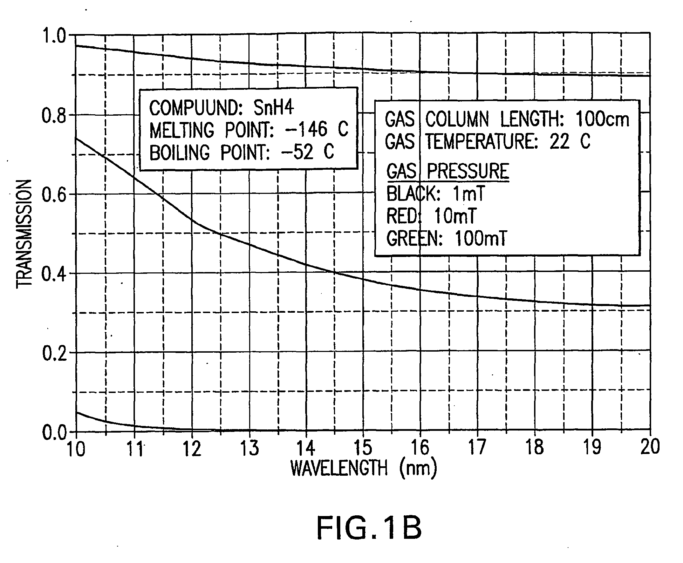

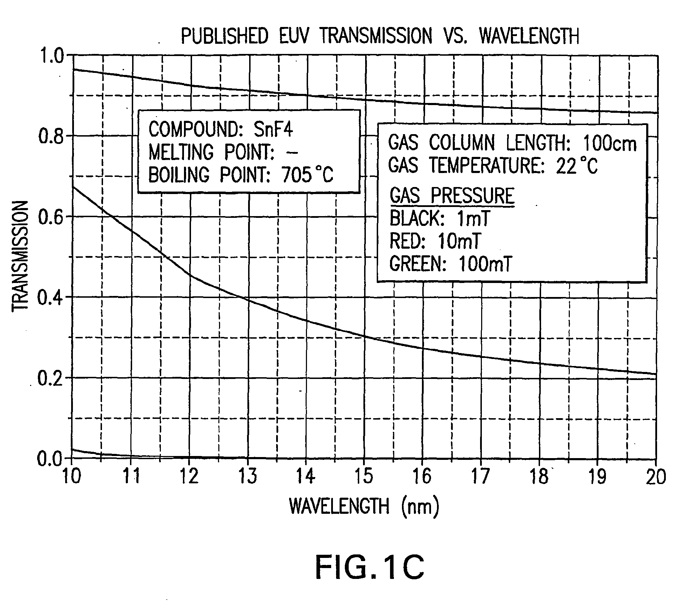

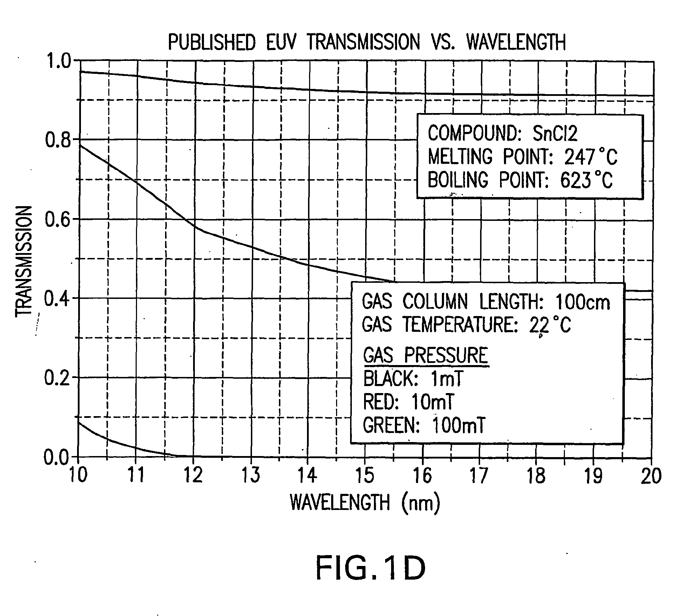

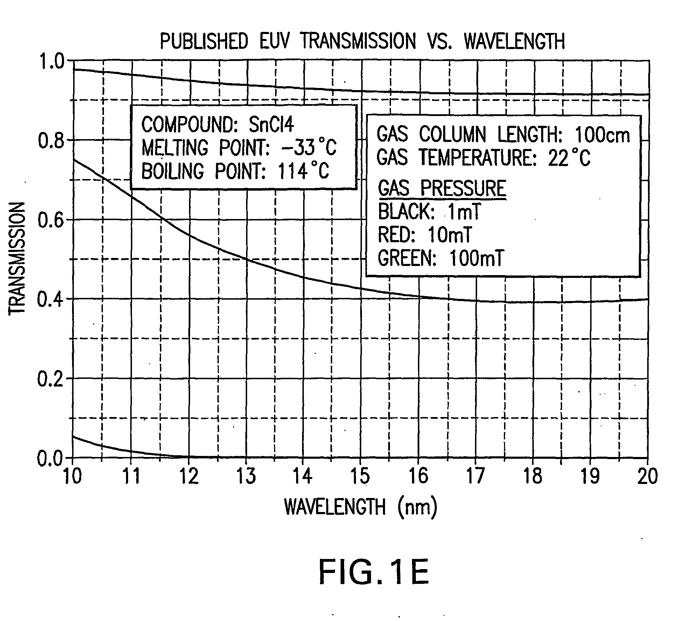

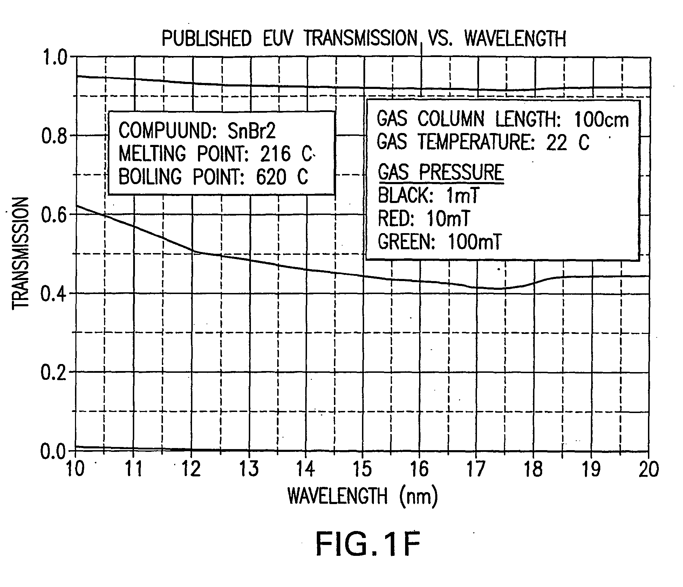

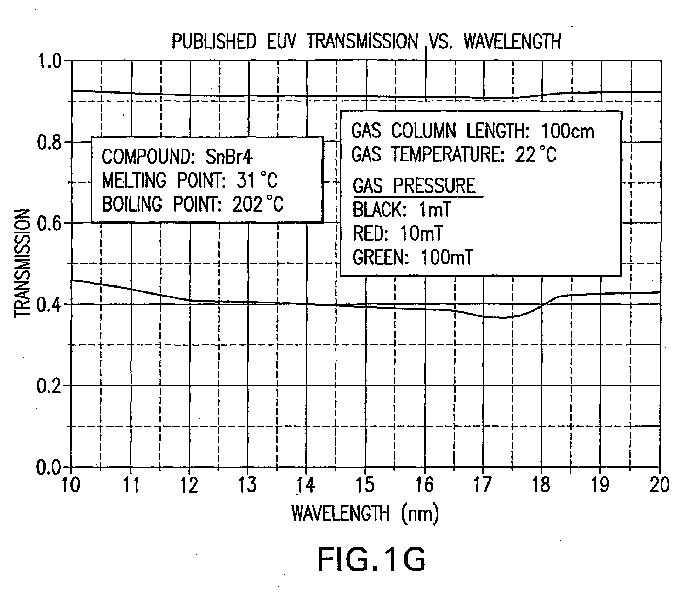

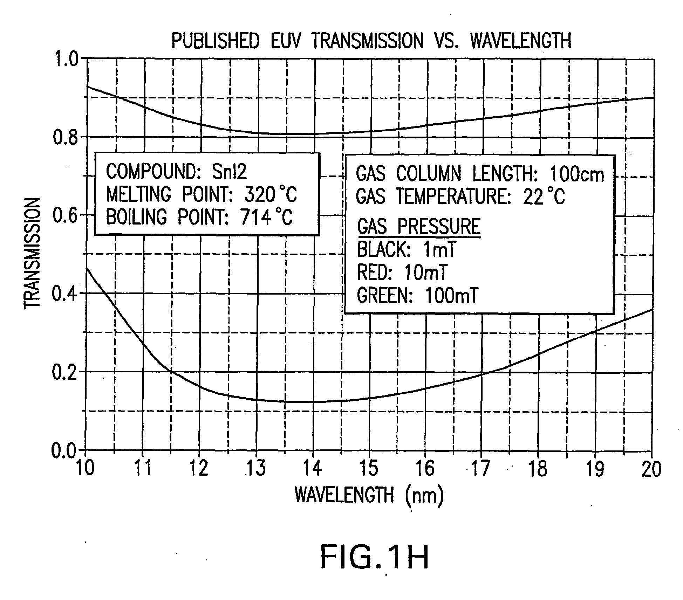

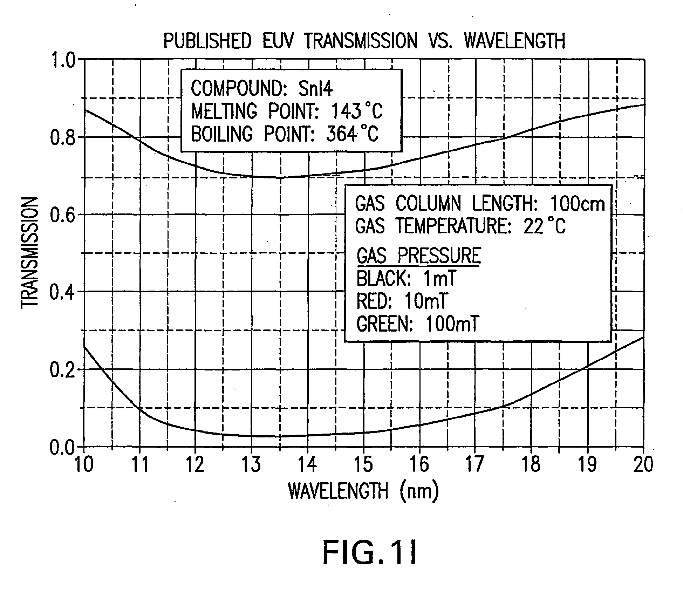

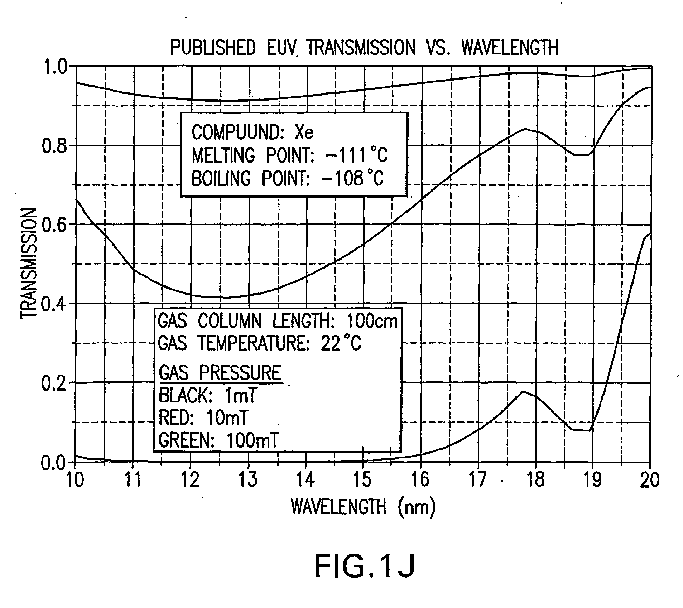

These plots also indicate that, except for the tin iodine compounds, the 13.5nm absorption is dominated by the tin atom and not the halide. These plots also show that for acceptable transmission, the gas pressure mostly has to be below 10mT. For comparison, the plot in FIG. 1J shows the EUV transmission of xenon. As can be seen, for Xenon the background pressure must be kept very low due to Xenon's very high absorption around 13.5 nm.

Applicants have examined EUV plasma source material halogen containing compounds, e.g. tin halides, regarding whether or not they will form on the mirror surface and carry away the tin, e.g., in a chemical and/or ion etch process at the surface of an optical element exposed to the debris in the EUV production chamber. While the hydride SnH₄ has previously been investigated by applicants in the literature and found to have a high activation energy, rendering the required average power incident, e.g., on the surface of the mirror impractical. Some others may suffer from a similar disadvantage, although other aspects of an environment in the EUV light plasma production chamber, such as the very presence of EUV (and for LPP DUV or other high energy) photons, the presence of induced secondary plasmas in the vicinity of the optical surfaces in question, stimulation of high energy bombardment of the optical surfaces, etc. may contribute to the lowering of the activation energy required and/or provide activation energy such that, as applicants believe, there will be almost no problem in forming halogen containing compounds, e.g., with just about any halogen, and e.g., with a source material debris such as tin. In any event, halogens such as Cl₂ and Br₂ react readily with tin in the cold (e.g., around room temperature and with F₂ and I₂ with some moderate warming above room temperature to form "SnX₄", where X is Cl, Br, F and I. The vapor pressures for the SnX₄ molecules is much higher than for the SnX₂ molecules, facilitating its utilization according to aspects of an embodiment of the present invention.

The real issue is to get the halogen containing compound to etch from, i.e., evaporate or be driven from the surface of the optical element and in what ambient environment(s). Chlorine and bromine and their compounds, e.g., HCl and HBr, appear to be the most likely successful cleaning agents, e.g., without additional activation energy stimulation. Hydrogen requires too much activation energy and the tin fluorine compounds may not evaporate from the mirror surface without additional stimulation to add activation energy.

Another issue to address is the prevention of unwanted etching of the material of the optical element, e.g., molybdenum, which, e.g., chlorine will readily do. Bromine and its compounds do not readily react with molybdenum, though it may a elevated temperatures, and appears to applicants to be a good choice for the halogen cleaning agent. The chamber will likely be operated at a temperature where bromine or its compounds are in the gas phase. In addition, one can cryo-pump the bromine or its compounds and the tin-bromide compounds from the chamber atmosphere utilizing simple water-cooled surfaces.

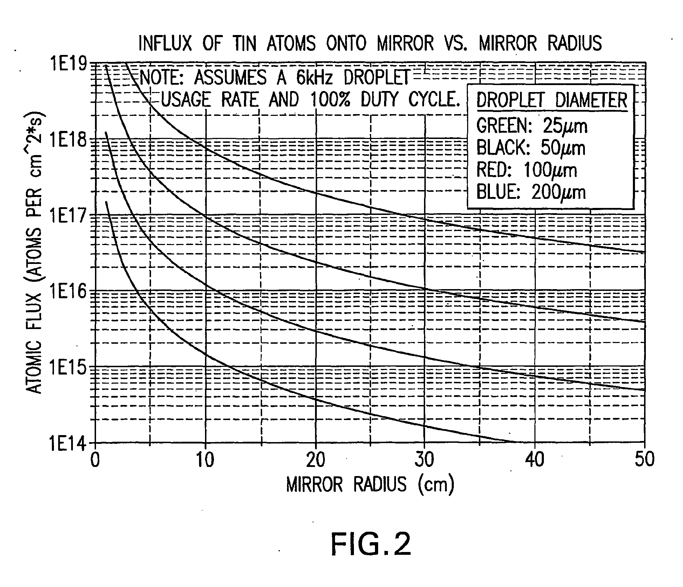

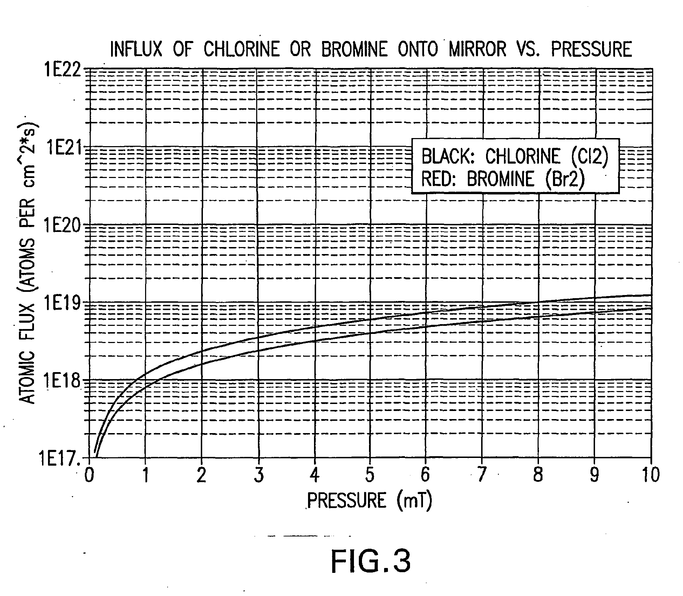

Applicants have also considered that with a given number of tin atoms deposited on, e.g., the mirror surface per unit time, what buffer pressure of chorine or bromine is required to continuously clean the mirror surface. Based upon the predicted influx rate calculation for tin against the mirror surface as shown in FIG. 2 for a given mirror size and the droplet diameter and the density of tin, per droplet assumed to be spewed evenly from the plasma into a full sphere, the resulting influx rate per unit surface area scales as the square of mirror radius. This influx rate of tin atoms according to aspects of an embodiment of the present invention must be accompanied by a sufficient rate of halogen atoms to form the volatile halogen containing compound, e.g., a tin halide. Given a flux of atoms (molecules) crossing a plane versus pressure and temperature, FIG. 3 shows a plot of the influx rate for chlorine and bromine.

The influx rate of the halogen or halogen containing gas according to aspects of an embodiment of the present invention will be orders of magnitude higher than the tin influx rate for a reasonable choice of mirror radii, e.g., around 20cm, which may be dictated by other operational considerations, e.g., cooling capability. A tin droplet diameter of 50µm leads to a tin influx rate at the mirror surface of 3 10¹⁵ atoms/cm²s as compared to a halogen influx rate of greater than 1 10¹⁸ to 10¹⁹ atoms/cm²s for any reasonable pressure. Thus, there will be plenty of halogen atoms available, and the issue becomes one of the reactivity rate in forming the metal halogen containing compound, e.g., SnBr₄. The source of Br may be, e.g., Br₂ or HBr gas contained in the plasma formation chamber.

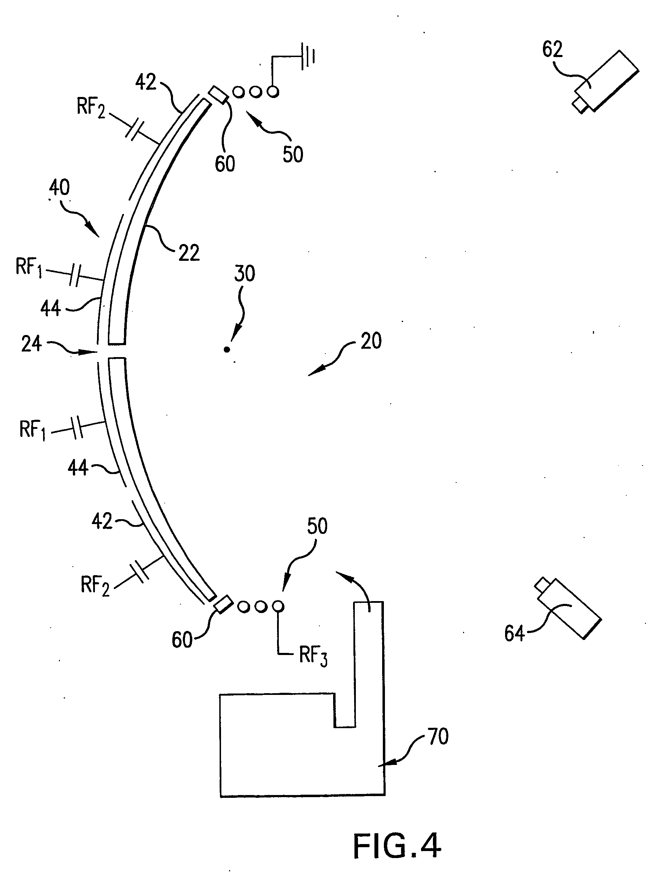

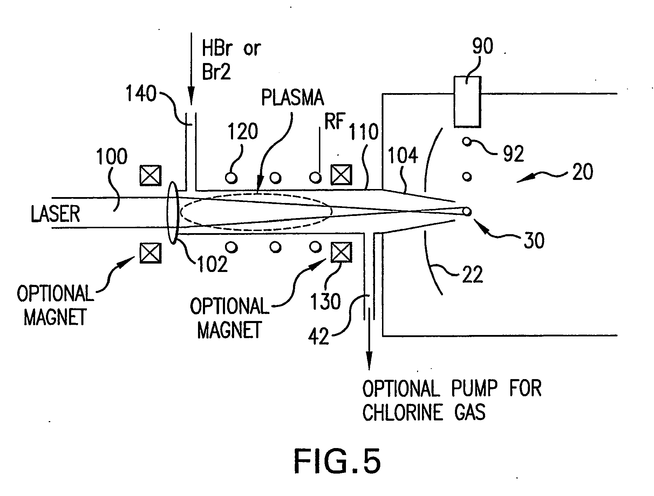

Turning now to FIG. 4 there is illustrated schematically a collector system 20 for an EUV LPP light source. The system 20 may comprise a collector 22, which may be in the form of a truncated ellipse, with a first focus at a desired plasma initiation site 30, to which targets, e.g., in the form of droplets 92 of liquid source material, e.g., tin, as shown schematically in FIG. 5. The droplets 92 may be delivered by a target delivery system 90, as discussed in more detail in some of the above referenced co-pending applications.

A laser beam(s) 100 may be delivered to the plasma initiation site 30, e.g., through an input and focusing optic 102 (shown in FIG. 5) to cause the formation of a plasma from the target under the irradiation of the laser beam 100. The chamber may be filled with a gas, e.g., a halogen containing gas, e.g., Br₂ or HBr or perhaps also HCl, providing a source of a halogen, e.g., Br or Cl, that will react with plasma source metal debris, e.g., tin atoms deposited on the collector 22 reflective surface and window/lens 102 optical surface facing the plasma initiation site 30.

The EUV light producing mechanism utilizing the plasma producing source material, e.g., tin, which comprises a source material that will form a halogen-containing-compound, which source material also produces EUV light from the induced plasma upon laser beam(s) irradiation in a band around a selected center wavelength, e.g., about 13.5nm. The collector 22 contained within the chamber may have a reflective surface containing at least one layer of a first material, e.g., molybdenum or ruthenium or silicon, or other metals of compounds thereof that does not form halogen containing compounds or forms a halogen containing compound layer (e.g., that does not significantly reduce the reflectivity of the reflective surface in the band). For example, the gas contained within the chamber may comprise a halogen or halogen compound with which the source material forms a halogen containing compound, which halogen containing compound has a vapor pressure that will allow etching of the halogen containing compound from the reflective surface. The gas therefore, constitutes a plasma source material etchant source gas, e.g., including a halogen or one of its compounds, e.g., HBr or Br₂. The etching may be purely by evaporation according to aspects of an embodiment of the present invention or may be stimulated, e.g., thermally, e.g., by heating the collector 22 or window/lens 102, by the presence of EUV and/or DUV photon energy, by a secondary plasma generated in the vicinity of the optical element 22, 102 or by a remotely generated plasma from which a source of ions and/or radicals may be introduced into the vicinity of the optical element 22, 102.

The system 20 may include a plurality of radio frequency or microwave (RF) generators that may deliver an RF₁ and an RF₂ to sectors of RF antennas capacitively coupled to the antennas 42, 44, which may cover the extent of the rear side of the collector 22 shape and deliver RF to induce ions in the vicinity of the collector 22 reflective surface facing the EUV plasma generation site to accelerate toward the reflective surface of the collector 22. These sectors may be segmented into squares, triangles hexagons, or other meshing geometric forma, or portions thereof to cover the surface area of the rear side of the collector to distribute the two or more RF frequencies differentially to different segments of the collector 22 reflective surface. A plasma may be induced in the vicinity of the collector 22, e.g., by RF source 50 connected between an RF source RF₃ and ground. this local or in situ plasma at the collector surface may both slow down debris in the form of non-ablated portions of the target 92 ejected from the plasma initiation site before being ionized and high energy ions from the EUV light source plasma, but may in addition serve to induce etching or evaporation of the volatile halogen-source material compound from the reflecting surfaces of the collector 22. The RF sector antennas 42, 44 inducing ions from the plasma to mechanically induce etching of the halogen-source material compound by reactive ion etching.

The in situ plasma in the working vicinity of the collector may be generated to both stimulate etching of the EUV plasma source material from, e.g., the collector 22, but also to chosen to block ions from reaching, e.g., the reflective surface of the collector 22, or at least slow them down significantly enough to avoid, e.g., sputtering of the reflective surface material(s) from the collector 22 reflective surface.

A remote plasma source 70 may be provided where, e.g., through RF inducement a plasma is formed comprising, e.g., ions in the form of radicals of, e.g., chlorine, bromine and their compounds, containing, e.g., a free electron, which may then be introduced to the chamber and form or contribute to the in situ plasma at the reflective surfaces of the collector 22.

The chamber may also contain a plurality of, e.g., two sacrificial witness plates or bars 60. The sacrificial witness plates or bars 60 may be observed, e.g., with a respective one of a pair of spectrometers 62, 64 to provide an indication that a base material of the witness plate or bar 60, e.g., molybdenum, ruthenium, silicon or the like is being etched, rather than the source material halogen compound. this can be utilized to control the plasma, e.g., lower the RF energy delivered to the plasma, e.g., the in situ plasma, to suppress unfavorable etching when the witness plates or bars being observed indicate that the source material-halogen compound has bee fully etched away for the time being. In lieu of the spectrometers 62, 64 a monochromator, sensitive to the wavelength emitted when the collector material begins to be etched on the witness plate 60 may be used. The witness plate(s) 60 may be of different base materials, including e.g., molybdenum, ruthenium, silicon, etc.

As shown in FIG. 5 a similar arrangement is provided for a window/lens 102, which is contained in a window tube 110, and may serve, e.g., to receive the laser light beam(s) 100 utilized for, e.g., LPP EUV light production. Such a window and other optical elements like it, e.g., for metrology purposes are a part of a laser system subsystem. The tube has a gas inlet 140 and a gas outlet 142 through which respectively a gas may be circulated through the tube 110. The etchant source gas, as with the chamber gas discussed above, may comprise a suitable halogen, e.g., in the form of HBr or Br2 or HCl or Cl2, and contributes to the formation of volatile plasma source material-halogen compounds on the side of the window potentially exposed to EUV plasma debris. This etching may be in turn stimulated by an RF induced plasma induced by RF coils 120 and the plasma may be magnetically confined in the tube, e.g., through permanent or electromagnets 130.

For the chamber laser lens/window 102 and other, e.g., diagnostic windows applicants propose to use halogen resistant, e.g., bromine-resistant optical materials such as CaF2 and MgF2. This cleaning may be done by the gas alone (stimulated by laser radiation going through as well as generated EUV radiation). Or, as noted the cleaning may use an RF plasma to stimulate window cleaning.

It will be understood that the laser subsystem optical element may be a window formed directly in the chamber wall, i.e., without the tube 110, and the etchant source gas may be in the chamber. In situ plasma and magnetic confinement may still be employed as noted above according to aspects of this embodiment of the present invention.

The halogen gases may be evacuated from the tube 110 before reaching the EUV plasma production chamber.

Those skilled in the art will appreciate that the above aspects of embodiments of the present invention relate to preferred embodiments only and the scope and intent of the appended claims and the inventions defined therein are not limited to such preferred embodiments.

## Claims

1. An EUV light producing apparatus for producing EUV light from a laser beam and EUV plasma source material comprising a material that will form an etching compound, said EUV light producing apparatus comprising an EUV plasma generation chamber (20), whereby said laser beam interacts with said EUV plasma source material to produce said EUV light in said EUV plasma generation chamber (20), said EUV plasma generation chamber (20) comprising a subsystem, said subsystem comprising:
a window tube (110) for receiving said laser beam, said window tube (110) having a gas inlet (140) and a gas outlet (142);
an optical element (102) comprising a material that does not form an etching compound and/or forms a compound layer that does not significantly reduce the optical performance of the material;
said EUV light producing apparatus being such that said gas inlet (140) is adapted to enable introduction of an etchant source gas into said window tube (110), said etchant source gas being in operative contact with said optical element (102) and comprising an etchant source material comprising bromine or chlorine with which the EUV plasma source material forms an etching compound, which etching compound has a vapor pressure that will allow etching of the etching compound from the optical element (102), said etching compound being evacuated from said window tube (110) via said gas outlet (142).

2. The apparatus of claim 1 further comprising: the etchant source material being selected based upon the etching being stimulated in the presence of photons of EUV light.

3. The apparatus of claim 1 further comprising: the etchant source material being selected based upon the etching being stimulated in the presence of photons of DUV light.

4. The apparatus of claim 1 further comprising: the etchant source material being selected based upon the etching being stimulated by the presence of high energy photons.

5. The apparatus of one claims 1 to 4 further comprising:
an etching stimulation plasma generator (120) providing an etching stimulation plasma in the working vicinity of the optical element (102); and
the etchant source material being selected based upon the etching being stimulated by an etching stimulation plasma.

6. The apparatus of claim 5 further comprising: a magnetic field generator (130) confining the etching stimulation plasma.

## Patentansprüche

1. EUV-Lichterzeugungsvorrichtung zum Erzeugen von EUV-Licht aus einem Laserstrahl und EUV-Plasma-Ausgangsmaterial, das ein Material umfasst, das eine Ätzverbindung bildet, wobei die EUV-Lichterzeugungsvorrichtung eine EUV-Plasmaerzeugungskammer (20) umfasst, der Laserstrahl mit dem EUV-Plasmaausgangsmaterial zum Erzeugen des EUV-Lichtes in der EUV-Plasmaerzeugungskammer (20) in Wechselwirkung tritt und die EUV-Plasmaerzeugungskammer (20) ein Teilsystem umfasst und das Teilsystem umfasst:
eine Fensterröhre (window tube) (110) zum Empfangen des Laserstrahls, wobei die Fensterröhre (110) einen Gaseinlass (140) und einen Gasauslass (142) aufweist;
ein optisches Element (102), das ein Material umfasst, das keine Ätzverbindung bildet und/oder eine Verbundschicht bildet, die die optische Leistung des Materials nicht nennenswert verringert;
die EUV-Lichterzeugungsvorrichtung so ausgeführt ist, dass der Gaseinlass (140) so eingerichtet ist, dass er Einleiten eines Ätzmittel-Ausgangsgases in die Fensterröhre (110) ermöglicht, wobei das Ätzmittel-Ausgangsgas in funktionalem Kontakt mit dem optischen Element (102) ist und ein Ätzmittel-Ausgangsmaterial umfasst, das Brom oder Chlor umfasst und mit das EUV-Plasma-Ausgangsmaterial eine Ätzverbindung bildet, wobei die Ätzverbindung einen Dampfdruck hat, der Ätzen der Ätzverbindung von dem optischen Element (102) zulässt, und die Ätzverbindung über den Gasauslass (142) aus der Fensterröhre (110) abgesaugt wird.

2. Vorrichtung nach Anspruch 1, die des Weiteren umfasst, dass das Ätzmittel-Ausgangsmaterial basierend darauf ausgewählt wird, dass das Ätzen beim Vorhandensein von Photonen von EUV-Licht stimuliert wird.

3. Vorrichtung nach Anspruch 1, die des Weiteren umfasst, dass das Ätzmittel-Ausgangsmaterial basierend darauf ausgewählt wird, dass das Ätzen beim Vorhandensein von Photonen von DUV-Licht stimuliert wird.

4. Vorrichtung nach Anspruch 1, die des Weiteren umfasst, dass das Ätzmittel-Ausgangsmaterial basierend darauf ausgewählt wird, dass das Ätzen durch das Vorhandensein von Photonen hoher Energie stimuliert wird.

5. Vorrichtung nach einem der Ansprüche 1 bis 4, die des Weiteren umfasst:
eine Ätzstimulations-Plasmaerzeugungseinrichtung (120), die ein Ätzstimulations-Plasma in der Arbeitsumgebung des optischen Elementes (102) bereitstellt; und
wobei das Ätzmittel-Ausgangsmaterial basierend darauf ausgewählt wird, dass das Ätzen durch ein Ätzstimulations-Plasma stimuliert wird.

6. Vorrichtung nach Anspruch 5, die des Weiteren umfasst:
eine Magnetfeld-Erzeugungseinrichtung (130), die das Ätzstimulations-Plasma einschließt.

## Revendications

1. Appareil de production de lumière ultraviolette extrême (UVE) pour produire une lumière UVE à partir d'un faisceau laser et d'une matière source de plasma UVE comprenant une matière qui va former un composé de gravure, ledit appareil de production de lumière UVE comprenant une chambre de génération de plasma UVE (20), ledit faisceau laser entrant en interaction avec ladite matière source de plasma UVE afin de produire ladite lumière UVE dans ladite chambre de génération de plasma UVE (20), ladite chambre de génération de plasma UVE comprenant un sous-système, ledit sous-système comprenant :
un tube formant fenêtre (110) pour recevoir ledit faisceau laser, ledit tube formant fenêtre (110) comprenant une admission de gaz (140) et une sortie de gaz (142) ;
un élément optique (102) comprenant une matière qui ne forme pas de composé de gravure et/ou forme une couche de composé qui ne réduit pas sensiblement la performance optique de la matière ;
ledit appareil de production de lumière UVE étant tel que ladite admission de gaz (140) est conçue pour permettre l'introduction d'un gaz source d'agent de gravure dans ledit tube formant fenêtre (110), ledit gaz source d'agent de gravure étant en contact fonctionnel avec ledit élément optique (102) et comprenant une matière source d'agent de gravure comprenant du brome et du chlore avec lesquels la matière source de plasma UVE forme un composé de gravure, lequel composé de gravure comprend une pression de vapeur qui va permettre la gravure du composé de gravure à partir de l'élément optique (102), ledit composé de gravure étant évacué dudit tube formant fenêtre (110) par l'intermédiaire de ladite sortie de gaz (142).

2. Appareil conformément à la revendication 1 comprenant en outre :
la matière source d'agent de gravure étant sélectionnée sur la base de la gravure stimulée en présence de photons de lumière UVE.

3. Appareil conformément à la revendication 1 comprenant en outre :
la matière source d'agent de gravure étant sélectionnée sur la base de la
gravure stimulée en présence de photons de lumière ultraviolette dangereuse (DUV).

4. Appareil conformément à la revendication 1 comprenant en outre :
la matière source d'agent de gravure étant sélectionnée sur la base de la gravure stimulée par la présence de photos d'énergie élevée.

5. Appareil conformément à l'une des revendications 1 à 4 comprenant :
un générateur de plasma de stimulation de gravure (120) fournissant un plasma de stimulation de gravure au voisinage de travail de l'élément optique (102) ; et
la matière source d'agent de gravure étant sélectionnée sur la base de la gravure stimulée par un plasma de stimulation de gravure.

6. Appareil conformément à la revendication 5 comprenant : un générateur de champ magnétique (130) confinant le plasma de stimulation de gravure.
